## Europäisches Patentamt
## European Patent Office
## Office européen des brevets

(11) Veröffentlichungsnummer: **0 107 071**
**A2**

(12) **EUROPÄISCHE PATENTANMELDUNG**

(21) Anmeldenummer: **83109559.1**

(22) Anmeldetag: **26.09.83**

(51) Int. Cl.³: **H 01 L 21/48, H 01 L 23/14**

(30) Priorität: **27.09.82 DE 3235675**

(43) Veröffentlichungstag der Anmeldung: **02.05.84**
**Patentblatt 84/18**

(84) Benannte Vertragsstaaten: **AT DE FR GB IT NL**

(71) Anmelder: **SIEMENS AKTIENGESELLSCHAFT, Berlin und München Wittelsbacherplatz 2, D-8000 München 2 (DE)**

(72) Erfinder: **Koch, Dirk, Leharstrasse 9 A, D-8900 Augsburg 21 (DE)**

(54) **Verfahren zur Herstellung von Halbleiterchip-Filmträgern.**

(57) Die Erfindung bezieht sich auf ein Verfahren zur Herstellung von Halbleiterchips-Filmträgern, die auf der einen Seite mit einer Kupferkaschierung versehen und im Kunststoffträgerbereich eine Aussparung für Halbleiterbauelemente enthalten. Bei derartigen Filmträgern muß zur Vermeidung von Metallabscheidungen auf der der Struktur abgewandten Seite das Folienband auf der Oberfläche einer entsprechenden Entwicklerlösung schwimmend von unten entwickelt werden. Auch alle übrigen Verfahrensschritte können nur einseitig vorgenommen werden, was zu einer erheblichen Verfahrenserschwernis führt. Zur Vereinfachung sieht die Erfindung vor, die Rückseite des Kunststoffträgers (3) mit einer Fotofolie (4) zu beschichten, anschließend die Fotolackschichtseite zu belichten und zum Entwickeln mit einem nur selektiv auf die Fotolackschicht (1) wirkenden Entwicklungsmedium zu arbeiten.

SIEMENS AKTIENGESELLSCHAFT          Unser Zeichen
Berlin und München                  VPA  82 P 1 8 6 3 E

**Verfahren zur Herstellung von Halbleiterchip-Filmträgern.**

Die Erfindung betrifft ein Verfahren zur Herstellung von Halbleiterchips-Filmträgern, die aus einem auf der einen Seite mit einer eine Fotolackschicht tragenden Kupferkaschierung versehenen Kunststoffträger bestehen, bei dem auf der von der Kupferkaschierung abgewandten Seite im Bereich des jeweiligen Halbleitereinbauplatzes eine Aussparung bis zur Kupferschicht vorgesehen ist und wobei die Leiterstruktur durch ein Fotoätzverfahren erzeugt ist.

Bei der Herstellung von "Filmen" als Träger für Halbleiterchips wird z. B. ein einseitig mit Cu-kaschierter Kunststoffträger mit Hilfe von photolithografischen Prozessen derart vorbereitet, daß die zur Strukturerzeugung freientwickelten Bereiche anschließend einseitig galvanisiert und geätzt werden können. Weil bei diesem Prozeß im Bereich des Halbleitereinbauplatzes der Kunststofferzeuger von der metallabgewandten Seite mit einer entsprechenden Aussparung versehen ist, besteht die Notwendigkeit, das von dieser Seite ungeschützte Kupfer gegenüber der galvanischen Abscheidung bzw. dem nachfolgenden Ätzprozeß abzudecken. Im Rahmen des bisher hierfür eingesetzten Prozesses wird eine doppelseitige Fotolackbeschichtung durch eine Tauchbeschichtung im Durchlaufverfahren vorgenommen. Bei der nachfolgenden Belichtung wird in die auf der Cu-Seite befindlichen Lackschicht die entsprechende Struktur belichtet. Zur Vermeidung von Metallabscheidungen auf der der Struktur abgewandten Seite wird das Folienband auf der Oberfläche einer entsprechenden Entwicklerlösung schwimmend von unten entwickelt. Hiernach wird das Folienband nach einer Vorreinigung mit einer galvanisch abgeschiedenen Metallschicht im Banddurchlaufverfahren versehen. Vor dem nachfolgenden Ätzschritt

Zk 1 Fdl/ 3. 8. 1982

darf das Folienband wiederum nur einseitig entschichtet werden, damit der rückwertige Lackschutz des Kupfers bestehen bleibt.

Während des Ätzens mit dem selektiven Ätzmittel dient die galvanisch erzeugte Schicht an dieser Stelle als Ätzreserve. Nach dem Ätzen wird das Folienband vollständig entschichtet, gereinigt und getrocknet. Der Film ist fertiggestellt und wird nun noch einer entsprechenden Endprüfung unterzogen.

Aufgabe der vorliegenden Erfindung ist es, bei einem Verfahren zur Herstellung von Halbleiterchip-Filmträgern, bei denen im Bereich des jeweiligen Halbleitereinbauplatzes eine Aussparung bis zur Kupferschicht vorgesehen ist, eine Bearbeitungsvereinfachung zu erreichen.

Zur Lösung dieser Aufgabe wird gemäß der Erfindung derart verfahren, daß die Rückseite des Kunststoffträgers mit einer Fotofolie beschichtet wird, daß anschließend die Fotolackschichtseite belichtet und zum Entwickeln mit einem nur selektiv auf die Fotolackschicht wirkendem Entwicklungsmedium gearbeitet wird.

Dadurch kann das Folienband vollständig in das Entwicklungsmedium eintauchen, wodurch die Bearbeitung derartiger Folienträger wesentlich vereinfacht wird.

Auf der Fotofolie kann eine Schutzfolie aufgebracht werden.

Die Fotolackschicht läßt sich dabei entweder im Roller-Coating oder im Gießschichtverfahren aufbringen.

Die Fotofolie kann mittels einer Laminiervorrichtung im Durchlaufverfahren aufgebracht werden.

0107071

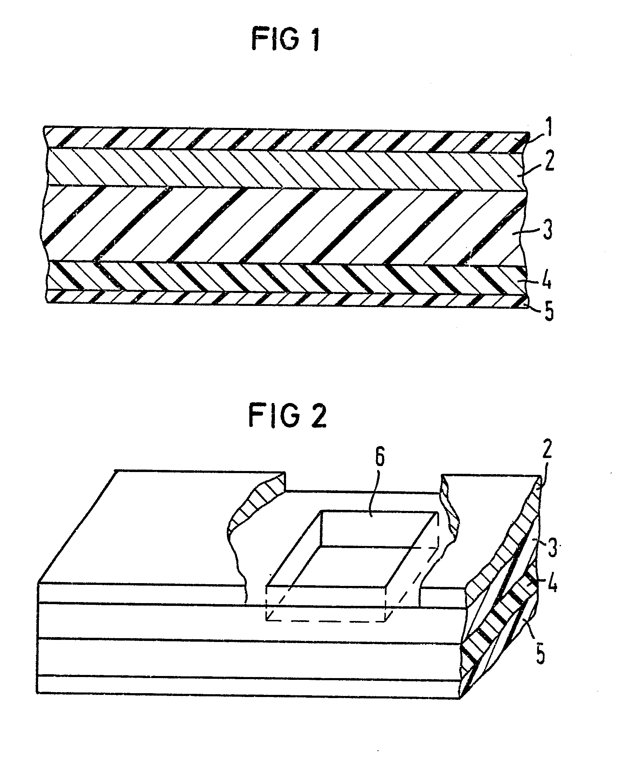

Anhand der Zeichnungen nach den Figuren 1 und 2 wird die Erfindung näher erläutert.

Es zeigen:

Fig. 1 einen Querschnitt durch den Filmträger mit den einzelnen Schichten,

Fig. 2 eine perspektivische Darstellung des Filmträgers unter Weglassung der Fotolackschicht.

Der Kunststoffträger 3 nach Fig. 1 enthält auf der einen Seite eine Kupferkaschierung 3, auf deren Oberseite eine Fotolackschicht 1 aufgebracht ist. Auf der Rückseite des Kunststoffträgers 3 wird eine Fotofolie 4 angebracht, die mit einer Schutzfolie 5 versehen ist.

Die perspektivische Darstellung nach Fig. 2 zeigt in der Mitte einen Durchbruch für einen Halbleiterchip. Die Fotolackschicht 1 ist zur Vereinfachung weggelassen. Der Durchbruch 6 für den Halbleiterchip ist lediglich im Kunststoffträger 3 vorgesehen und wird auf der einen Seite durch die Kupferfolie 2 und auf der anderen Seite durch die Fotofolie 4 begrenzt.

Anstelle der beidseitigen Lackbeschichtung ist also nur noch eine einseitige Lackbeschichtung, z. B. mit einem Roller-Coater oder einer Gießbeschichtung auf der Strukturseite vorgenommen. Nach dem Trocknen dieser Lackschicht 1 wird die Rückseite mit einer Fotofolie 4 im Durchlaufverfahren mittels einer entsprechenden Laminiervorrichtung, wie z. B. einem Hot-Roll-Laminator beschichtet. Anstelle dieser Fotofolie kann auch ein entsprechend normaler Lack oder eine Folie aufgebracht werden.

Im folgenden wird der Prozess anhand der Fotofolie beschrieben.

-4-

Die Belichtung wird in gewohnter Weise vorgenommen.

Bei dem Entwicklungsprozeß wird mit einer nur auf den belichteten Bereich des Fotolacks wirksamen Entwicklerlösung gearbeitet. Das in diesem Fall selektiv wirksame Entwicklungsmedium gestattet ein vollständiges Eintauchen des Folienbandes, zumal die die Fotofolie abdeckende Schutzfolie 5 im Gegensatz zu dem bei der Leiterplattenherstellung üblichen Entwicklungsvorgang nicht entfernt wird.

In Verbindung mit der die Rückseite abdeckenden Fotofolie stellt diese die eigentliche Fotofolie gegenüber Beschädigungen schützende Schutzfolie 5 einen zusätzlichen Schutz gegenüber den sogenannten Metalldurchschlägen während des galvanischen Prozesses dar.

Nach der galvanischen Abscheidung erfolgt die Entschichtung in gleicher Weise wie die zuvor geschilderte Entwicklung. Auch bei dieser Entschichtung braucht nicht mehr einseitig gearbeitet werden. Beim Ätzen wird die Rückseite durch die Fotofolie in ähnlicher Weise geschützt, wie bei der galvanischen Abscheidung.

Die abschließende Entschichtung kann entweder einseitig, mit einem entsprechenden beide Resistsysteme auflösenden Lösemittel vorgenommen werden, oder aber zweistufig, indem zuerst der Fotolack 1 mit einem selektiven Entschichtungsmittel und anschließend die Fotofolie 4 mit einem chlorierten Kohlenwasserstoff vollständig entschichtet werden. Zu beachten ist hierbei, daß die die Fotofolie schützende Folie 5 vor dem Entschichten entfernt werden muß. Das Entfernen dieser Folie 5 erfolgt rein mechanisch und kann unmittelbar vor dem Einlauf in die Entschichtungslösung vorgenommen werden.

2 Figuren
4 Patentansprüche

-5-    VPA    82 P 1 8 6 3 E

Patentansprüche

1. Verfahren zur Herstellung von Halbleiterchips-Filmträgern, die aus einem auf der einen Seite mit einer eine Fotolack- schicht tragenden Kupferkaschierung versehenen Kunststoff- träger bestehen, bei dem auf der von der Kupferkaschierung abgewandten Seite im Bereich des jeweiligen Halbleitereinbauplatzes eine Aussparung bis zur Kupferschicht vorgesehen ist und bei dem die Leiterstruktur durch ein Foto- ätzverfahren erzeugt ist, d a d u r c h   g e k e n n - z e i c h n e t , daß die Rückseite des Kunststoffträgers (3) mit einer Fotofolie (4) beschichtet wird, daß anschließend die Fotolackschichtseite belichtet und zum Entwickeln mit einem nur selektiv auf die Fotolackschicht (1) wirkendem Entwicklungsmedium gearbeitet wird.

2. Verfahren nach Anspruch 1, d a d u r c h   g e - k e n n z e i c h n e t , daß auf die Fotofolie (4) eine Schutzfolie (5) aufgebracht wird.

3. Verfahren nach einem der vorhergehenden Ansprüche, d a d u r c h   g e k e n n z e i c h n e t , daß die Fotolackschicht (1) im Roller-Coating oder Gießschichtverfahren aufgebracht wird.

4. Verfahren nach einem der vorhergehenden Ansprüche, d a d u r c h   g e k e n n z e i c h n e t , daß die Fotofolie (4) mittels einer Laminiervorrichtung im Durchlaufverfahren aufgebracht wird.

1/1

## FIG 1

## FIG 2